# EUROPEAN PATENT APPLICATION

(11) **EP 3 836 233 A1**
(43) Date of publication of application: **16.06.2021**
(21) Application number: 19828181.8
(22) Date of filing: 14.03.2019
(51) Int. Cl.: H01L 31/18, H01L 31/0352

(54) **FLEXIBLE SOLAR CELL AND MANUFACTURING METHOD THEREFOR**

(30) Priority: 09.08.2018 CN 201810904936; 22.02.2019 CN 201910132351
(71) Applicant: Suzhou Institute of Nano-tech and Nano-bionics (SINANO) Chinese Academy of Sciences, Suzhou, Jiangsu 215123 (CN)
(72) Inventor: LONG, Junhua, Suzhou, Jiangsu 215123 (CN); LU, Shulong, Suzhou, Jiangsu 215123 (CN); HUANG, Xinping, Suzhou, Jiangsu 215123 (CN); LI, Xuefei, Suzhou, Jiangsu 215123 (CN)
(74) Representative: Lang, Christian
(86) International application number: PCT/CN2019/078134
(87) International publication number: WO 2020/029581

(57) **Abstract**

The present disclosure provides a flexible solar cell and a manufacturing method thereof. The manufacturing method includes disposing a flexible substrate on a back electrode to transfer to the solar cell unit and the flexible substrate onto a temporary substrate, and then separating the temporary substrate from the flexible substrate after the flexible solar cell is manufactured. Thus, it reduces tedious bonding and de-bonding operations in manufacturing process of the flexible solar cell, can improve production efficiency, and avoids damage of cells by a high-temperature condition required for bonding. Also, the process is quick and not easy to damage the solar cell. The front electrode, back electrode and flexible substrate in the flexible solar cell all can be prepared by plating, with a relatively low cost and low requirement for equipment, which is conductive to mass production in industry.

## Description

### TECHNICAL FIELD

The present disclosure relates to a technical field of solar cells, and particularly to a flexible solar cell and a manufacturing method thereof.

### BACKGROUND ART

Flexible solar cells have a wide market in various fields due to their advantages such as good flexibility, high mass-power ratio and portable. In the prior art, flexible solar cells are difficult to be mass-production, and the cost thereof remains high. The reasons are mainly as follows: the flexible solar cell, especially a multi-junction flexible solar cell, itself has a brittle material such that it is easy to break when its area becomes relatively larger. And it is difficult to solve this problem by using a manufacturing method inwhich an epitaxial layer part of the flexible solar cell is transferred to a rigid substrate. For example, a secondary temporary bonding method is often used to manufacture large-area multi-junction flexible solar cells in the prior art. In particular, an flipped solar cell unit is formed on an epitaxial substrate by an epitaxially growth, a back electrode is formed on the bottom surface of the solar cell unit through an electron beam evaporation process or a megnetron sputtering process, a temporary substrate is temporarily bonded on the back electrode by a first temporarily bonding process, then the epitaxial substrate on the front surface of the solar cell unit is separated, a front electrode is formed on the front surface of the solar cell unit through the electron beam evaporation process or the megnetron sputtering process, another temporary substrate is bonded on the front electrode through a second temporarily bonding process, then a flexible substrate is formed on the back electrode after de-bonding the first temporary substrate and the back electrode, and finally the required multi-junction flexible solar cell is obtained by de-bonding the second temporary substrate and the solar cell unit.

However, the above secondary temporary bonding method has the following defects: since there are two bonding operations, the process is complicated and it is necessary to repeatedly bond using a bonder and de-bond using a de-bonding reagent and other auxiliary means, the production cost is relatively high and the production efficiency is relatively low. The first bonding operation is performed under a high requirement for a surface roughness of the solar cell, that is, the surface roughness of the solar cell is required to be small enough, and the de-bonding is relatively complicated. The bonding operation shall be conducted at a high temperature, and since different materials have different thermal expansion coefficients, resulting in a warpage at the high temperature and a decline in the yield rate.

### SUMMARY

On this account, an object of the present disclosure is to provide a flexible solar cell and a manufacturing method thereof, so as to solve the above problems.

To achieve the above purpose, the technical solution used by the present disclosure is:
the present disclosure provides a manufacturing method of a flexible solar cell, including: disposing a separation layer on a substrate; flip-chip fabricating a solar cell on the separation layer; disposing a back electrode on the bottom surface of the solar cell; disposing a metal thin film on the back electrode; bonding the metal thin film to a temporary substrate; separating the separation layer from the solar cell; disposing a front electrode on the front surface of the solar cell; and de-bonding the temporary substrate and the metal thin film.

Preferably, the separation layer is a corrosion barrier layer, wherein the separating the separation layer from the solar cell includes: corroding and removing the substrate by wet peeling; and peeling off and removing the corrosion barrier layer by wet peeling.

Preferably, the separation layer is a sacrificial layer, wherein the separating the separation layer from the solar cell includes: removing the sacrificial layer by wet peeling.

Preferably, after disposing the front electrode on the front surface of the solar cell, the manufacturing method also includes: depositing an anti-reflection film on the front electrode.

Preferably, the solar cell is a multi-junction solar cell.

Preferably, the bonding the metal thin film to the temporary substrate includes: bonding the metal thin film and the temporary substrate by using a low temperature bonding adhesive at a low temperature.

Preferably, the low temperature bonding adhesive is a low temperature cured silica gel.

Preferably, the de-bonding the temporary substrate and the metal thin film includes: cleaning and removing the low temperature bonding adhesive by using a low temperature adhesive cleaner.

Preferably, the disposing a metal thin film on the back electrode includes: forming the metal thin film by plating on the back electrode using a plating process; and performing a mechanical-chemical polishing on a surface of the metal thin film.

The present disclosure provides a flexible solar cell made by the above manufacturing method of the flexible solar cell.

The present disclosure provides a manufacturing method of a flexible solar cell, which includes: disposing an upside-down solar cell unit on a first rigid substrate; disposing a back electrode and a flexible substrate disposed to be laminated on the bottom surface of the solar cell unit; attaching the flexible substrate on a second rigid substrate coated with a binder and curing the binder by baking, to attach the flexible substrate to the second rigid substrate; separating the first rigid substrate from the solar cell unit; disposing a front electrode on the front surface of the solar cell unit; and peeling off the second rigid substrate.

Preferably, the disposing an upside-down solar cell unit on a first rigid substrate includes: disposing a corrosion barrier layer on the first rigid substrate; and disposing the flipped solar cell unit on the corrosion barrier layer.

Preferably, the disposing a back electrode and a flexible substrate disposed to be laminated on the bottom surface of the solar cell unit includes: plating a back seed layer on the bottom surface of the solar cell unit; plating the back electrode on the back seed layer; and plating a metal thin film on the back electrode to form the flexible substrate.

Preferably, the metal thin film is a cooper thin film, and the second rigid substrate is borosilicate glass.

Preferably, the binder is a peelable silica gel of which an adhesion strength to the second rigid substrate is greater than that to the flexible substrate.

Preferably, the separating the first rigid substrate from the solar cell unit includes: corroding and removing the first rigid substrate on the corrosion barrier layer by a wet peeling process; after corroding and removing the first rigid substrate on the corrosion barrier layer by a wet peeling process, the manufacturing method of the flexible solar cell further includes: corroding and removing the corrosion barrier layer on the solar cell unit by the wet peeling process.

Preferably, the disposing a front electrode on the front surface of the solar cell unit includes: plating a front seed layer on the front surface of the solar cell unit; and plating a front electrode on the front seed layer.

Preferably, after disposing the front electrode on the front surface of the solar cell unit, the manufacturing method of the flexible solar cell further includes: disposing an anti-reflectance layer on the front electrode of the solar cell unit and an area on the front surface of the solar cell unit that is not covered by the front electrode.

Preferably, the solar cell unit is a multi-junction solar cell.

Compared with a scheme that requires repeatedly bonding, and repeatedly transferring an epitaxial layer in the prior art, the flexible solar cell and the manufacturing method thereof provided in the present disclosure reduce the bonding and de-bonding operations, enhance the production efficiency, have the application value of industrialization, and can avoid damage of cells by a high-temperature condition required for bonding. After the flexible solar cell has been manufactured, it is possible to separate the temporary substrate from the flexible substrate directly. The process is quick and not easy to damage the cell. Moreover, the front electrode, back electrode and flexible substrate in the flexible solar cell all can be prepared by plating, with a relatively low cost and low requirement for equipment.

### BRIEF DESCRIPTION OF THE DRAWINGS

Fig. 1 is a flowchart of a manufacturing method of a flexible solar cell provided in embodiment 1 of the present disclosure;
Fig. 2 is a flowchart of disposing a metal thin film on a back electrode in embodiment 1 of the present disclosure;
Fig. 3 is a process flowchart of the flexible solar cell in embodiment 1 of the present disclosure;
Fig. 4 is a structural diagram of a cell unit of the flexible solar cell in embodiment 1 of the present disclosure;
Fig. 5 is a flowchart of a manufacturing method of a flexible solar cell provided in embodiment 2 of the present disclosure;
Fig. 6 is a process flowchart of a flexible solar cell corresponding to Fig. 5;
Fig. 7 is a structural diagram of the flexible solar cell provided in embodiment 2 of the present disclosure; and
Fig. 8 is a relationship diagram between current density and voltage of the flexible solar cell manufactured in embodiment 2 of the present disclosure in AM 1.5G spectrum.

### DETAILED DESCRIPTION

In order for the purpose, technical solution and advantages of the present disclosure to be clearer, the specific implements of the present disclosure will be further explained in details below in conjunction with the drawings. The example of these preferred implements are exemplified in the drawings. Implements of the present disclosure shown in the drawings and described according to the drawings are exemplary only, and the present disclosure is not limited to these implements.

Herein, it should be also noted that the drawings merely show structures and/or processing steps closely related to the scheme according to the present disclosure, but the less related other details are omitted, in order to avoid blurring the present disclosure due to unnecessary details.

### Embodiment 1

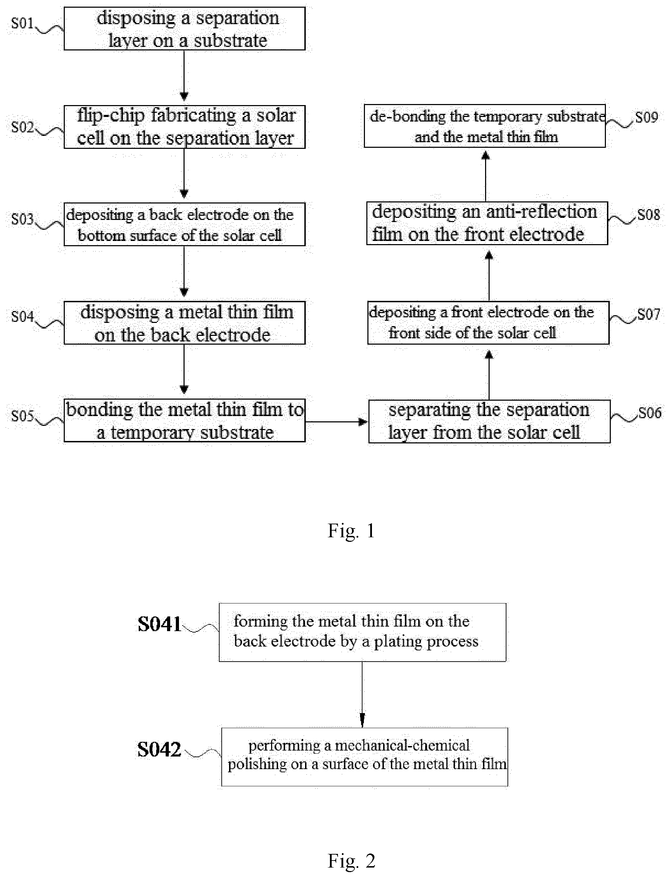

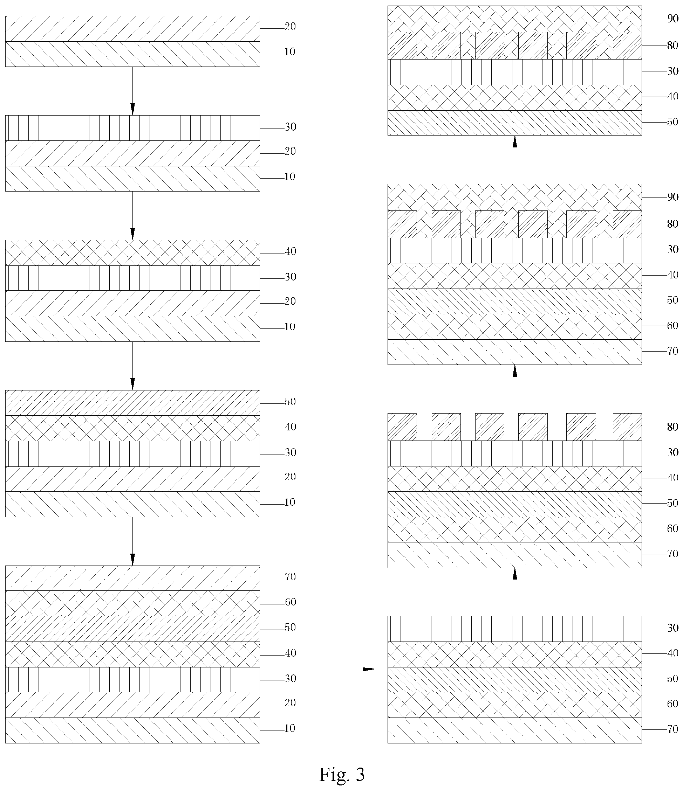

As shown in Figs. 1 and 3, the present disclosure provides a manufacturing method of a flexible solar cell, including:
S01, disposing a separation layer 20 on a substrate 10. Wherein the substrate 10 adopts a semiconductor material GaAs of which a material band gap matches the solar spectrum better, which is advantage for providing efficient multi-junction solar cells. The separation layer 20 is a sacrificial layer of which a material is AlAs, and the sacrificial layer is a structure to be removed while separating the substrate from the solar cell.
S02, flip-chip fabricating a solar cell 30 on the separation layer 20. In order to obtain the solar cell 30 having a higher photoelectric conversion efficiency, the solar cell 30 may be arranged to be a triple-junction solar cell, a four-junction solar cell or a multi-junction solar cell so that the cell can absorb light in different wavelengths. In the present embodiment, each junction of the solar cell 30 is a cell unit.

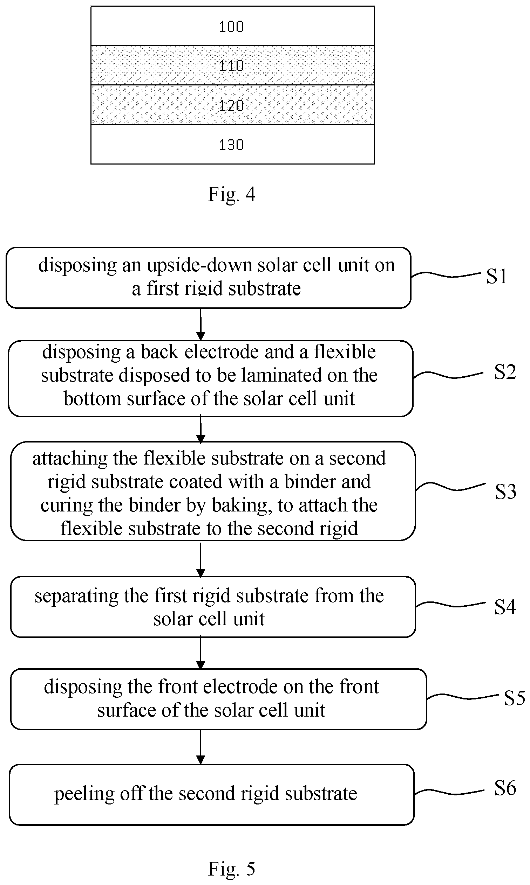

As shown in Fig. 4, each of the cell units has a window layer 100, an emitter region 110, a base region 120 and a back-surface field layer 130. A surface where the window layer 100 is located is the front surface of the solar cell 30, and a surface where the back-surface field layer 130 is located is the bottom surface of the solar cell 30. When the solar cell 30 is fabricated, the solar cell 30 flip-chip fabricates, that is, the window layer 100, the emitter region 110, the base region 120 and the back-surface field layer 130 are sequentially formed on the substrate when each cell unit of the solar cell 30 is prepared.

S03, depositing a back electrode 40 on the bottom surface of the solar cell 30. The back electrode 40 has a material of Ti/Pt/Au. A specific method of the deposition process is: evaporating Ti/Pt/Au by electron beams, depositing it on the bottom surface of the solar cell 30 to form the back electrode 40, and then rapidly annealing the back electrode 40 so that it can form ohmic contact with the solar cell 30.

S04, disposing a metal thin film 50 on the back electrode 40 as a flexible substrate. In conjunction with Fig. 2, the disposing the metal thin film 50 on the back electrode 40 in the embodiment specifically includes:
S041, depositing the metal thin film 50 on the back electrode 40 by a plating process. The metal thin film 50 has a material of Cu which has good ductility and can be used as a flexible substrate.
S042, performing a mechanical-chemical polishing on a surface of the metal thin film 50. Since the bonding process has a relatively high requirement for a roughness of the operating surface, it is necessary to make the roughness of the surface as small as possible. The mechanical-chemical polishing can be performed on the metal thin film 50, and after the polishing process, the metal thin film 50 has a thickness of 10 µm to 20 µm. Rather, if the metal thin film 50 prepared by the plating process of the previous step is smooth enough, a roughness of its surface is small enough to meet the requirements of bonding process, and thus step S042 of performing mechanical-chemical polishing on the surface of the metal thin film 50 may be omitted.
S05, bonding the metal thin film 50 to a temporary substrate 70. The bonding process is performed in a vacuum environment. High vacuum contributes to the discharge of gas molecules at a bonding interface, and increases a contact area. A low temperature bonding adhesive 60 is used to adhere the metal thin film 50 on the temporary substrate 70. The temporary substrate 70 is made of a material similar to the thermal expansion coefficient of the solar cell, the material may be GaAs or glass. The low temperature bonding adhesive 60 is a low temperature curing silica gel with a thermal curing temperature of 90°C and a thermal stability temperature of 300°C.
S06, separating the separation layer 20 from the solar cell 30. In the present embodiment, the separation layer 20 is a sacrificial layer. A method of separating the sacrificial layer from the solar cell 30 is a wet peeling process through which the sacrificial layer is corroded. It is possible to implement a separation of the substrate 10 and the solar cell 30, and the separated substrate 10 may not be broken and can be reused.
S07, depositing a front electrode 80 on the front surface of the solar cell 30. After being separated from the substrate, the front surface of the solar cell 30 will be exposed, the front electrode 80 is deposited on the front surface of the solar cell 30. The front electrode 80 has a material of AuGe/Ni/Au, and after deposition, ohmic contact may be formed with the solar cell 30 without annealing. AuGe/Ni/Au is a comb-shaped structure that makes it possible to let light irradiate on the solar cell 30 and also possible to realize current collection. If the solar cell 30 made at one time are relatively large, isolation grooves can be etched on the solar cell 30 to split the solar cell 30 into the required size.
S08, depositing an anti-reflection film 90 on the front electrode 80. The anti-reflection film 90 covers the front electrode 80 that greatly reduces the reflection of the light on the surface of the solar cell 30, so that much more light can be absorbed by the solar cell 30, thereby improving an energy conversion efficiency of the solar cell 30.
S09, de-bonding the temporary substrate 70 and the metal thin film 50. Since a stress exists between the metal thin film 50 and the temporary substrate 70, as the low temperature bonding adhesive gradually dissolves by using the low temperature adhesive cleaner, the stress between the metal thin film 50 and the temporary substrate 70 due to a difference of lattice constant and thermal expansion coefficient may separate the metal thin film 50 from the temporary substrate 70, that is, the flexible solar cell can be obtained, and the separated temporary substrate 70 may not be broken and can be reused.

As a preferred embodiment, the solar cell 30 described in the present embodiment has three cell units, i.e., GaInP sub-cell, GaAs sub-cell and InGaAs sub-cell. The solar cell 30 is formed on the substrate by sequentially disposing the GaInP sub-cell, the GaAs sub-cell and the InGaAs sub-cell. A band gap of the GaInP sub-cell is 1.88 eV, a band gap of the GaAs sub-cell is 1.42 eV, and a band gap of the InGaAs sub-cell is 1.05 eV. The InGaAs sub-cell is mismatched growth.

As another preferred embodiment, it is different from the previous embodiment that the separation layer 20 is a corrosion barrier layer which is used for preventing damage to the solar cell when separating the substrate and the solar cell, and the corrosion barrier layer has a material of GaInP. The separating the separation layer 20 from the solar cell 30 is peeling off the substrate 10 by using a wet peeling method, where a solution for removing the substrate 10 may be a mixed solution of hydrogen peroxide, ammonia and water, with this the corrosion barrier layer functions to protect the solar cell 30, and then wet peeling method is used again to peel off the corrosion barrier layer by using a wet peeling method after the substrate 10 has been fully corroded, where the solution for removing the corrosion barrier layer may be a mixed solution of hydrochloric acid and phosphoric acid. After the corrosion is completed, the front surface of the solar cell 30 is exposed. This method may destroy the substrate 10, which cannot be reused.

The present embodiment provides a flexible solar cell and the above manufacturing method, performing bonding and de-bonding only once during forming a flexible solar cell. Compared with the twice bonding and de-bonding in the prior art, the present invention is much easier and improves production efficiency. The de-bonding process is quick and does not damage the flexible solar cell and the temporary substrate 70. With the plated metal thin film 50 used as a flexible substrate due to the ductility thereof, it not only has a good flexibility, but also reduces the production cost, which has industrial application value.

### Embodiment 2

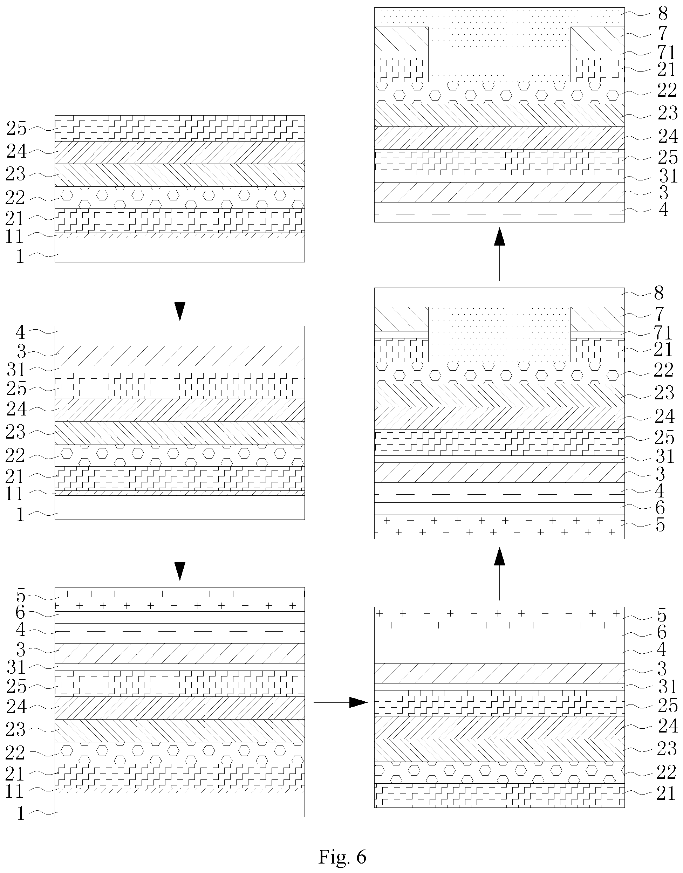

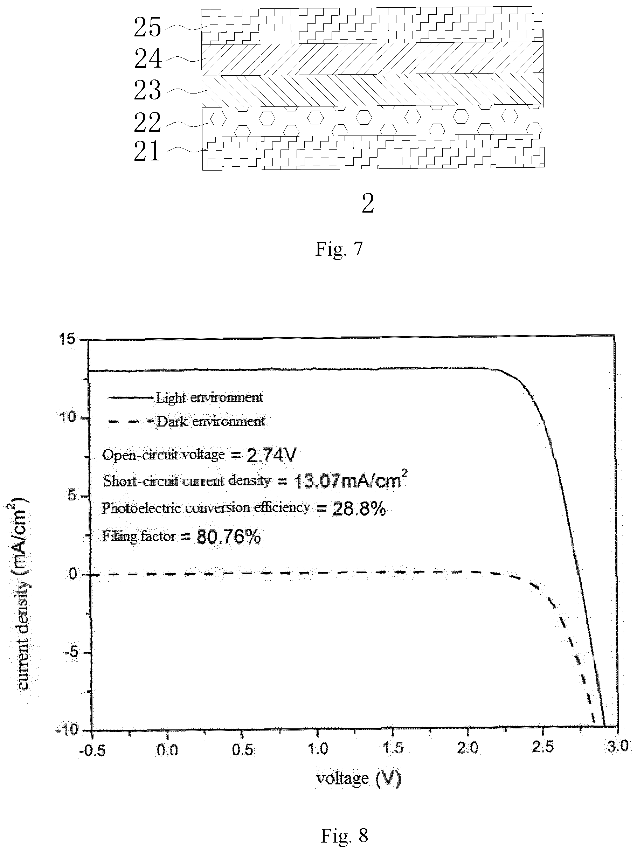

As shown in Figs. 5 and 6, the present embodiment provides another manufacturing method of the flexible solar cell, the manufacturing method includes:
S1, disposing an upside-down solar cell unit 2 on a first rigid substrate 1, the solar cell unit 2 corresponding to the cell unit of the solar cell 30 in embodiment 1. Here, in conjunction with Fig. 7, the solar cell unit 2 includes a front contact layer 21, a window layer 22, an emitter region 23, a base region 24, and a back contact layer 25 sequentially laminated on the first rigid substrate 1. A face where the front contact layer 21 is located is the front surface of the solar cell unit 2, from which light needs to be incident, and a face where the back contact layer 25 is located is the bottom surface of the solar cell unit 2.

In the present embodiment, specifically, the disposing an upside-down solar cell unit 2 on a first rigid substrate 1 includes:
disposing a corrosion barrier layer 11 on the first rigid substrate 1; and
disposing the upside-down solar cell unit 2 on the corrosion barrier layer 11.

The corrosion barrier layer 11 can prevent corrosion of the corrosive solution to the solar cell unit 2 when the first rigid substrate 1 on the corrosion barrier layer 11 is corroded and removed by using the wet peeling process, so as to protect the solar cell unit 2. The corrosion barrier layer 11 corresponds to the separation layer 20 in embodiment 1. The corrosion barrier layer 11 has a thickness of 150-170 nm, preferably 160 nm.

More specifically, GaAs substrate is selected as the first rigid substrate 1, and the front contact layer 21, the window layer 22, the emitter region 23, the base region 24 and the back contact layer 25 of the solar cell unit 2 are subsequently epitaxially grown on the GaAs substrate, to form an upside-down solar cell unit 2. In the present embodiment, the solar cell unit 2 is a multi-junction solar cell. As an example, the solar cell unit 2 is GaInP/GaAs/InGaAs triple-junction solar cell, GaInP solar cell, GaAs solar cell, and InGaAs solar cell are sequentially flip-chip fabricated on the first rigid substrate. Band gaps of the GaInP/GaAs/InGaAs triple-junction solar cell, the GaInP solar cell, the GaAs solar cell, and the InGaAs solar cell are 1.9 eV, 1.42 eV, and 1.05 eV The InGaAs solar cell is mismatched growth.

S2, disposing a back electrode 3 and a flexible substrate 4 disposed to be laminated on the bottom surface of the solar cell unit 2. The back electrode 3 forms ohmic contact on the bottom surface of the solar cell unit 2.

Specifically, the disposing a back electrode 3 and a flexible substrate 4 disposed to be laminated on the bottom surface of the solar cell unit 2 includes:
plating a back seed layer 31 on the bottom surface of the solar cell unit 2;
plating the back electrode 3 on the back seed layer 31; and
plating a metal thin film on the back electrode 3 to form the flexible substrate 4.

When electrode is required to be plated, a seed layer such as Ni thin film is plated on a contact layer, and then an electrode for ohmic contact is formed on the seed layer by plating, which contributes to stability of the electrode. As an example, the back electrode 3 includes metals such as Ti, Pt, Au, Cu and the like or alloys, and has a thickness less than 500 nm. Compared with cooper, Kovar alloy has a thermal expansion coefficient more similar to that of a cell material. It is more conducive to reducing the effect of stress on cell performance. Thus, in the embodiment, the metal thin film is preferred to be a Kovar alloy thin film. By using the thin film plated on the back electrode 3 as a flexible substrate, the thin film has the thickness of 10 µm to 20 µm, preferably 15 µm. Furthermore, an anti-oxidation treatment is also needed for a surface of the flexible substrate 4.

S3, attaching the flexible substrate 4 on a second rigid substrate 5 coated with a binder 6 and curing the binder 6 by baking, to attach the flexible substrate 4 onto the second rigid substrate 5. The second rigid substrate 5, as a temporary substrate for transferring the epitaxial layer part of the solar cell unit 2, is made of borosilicate glass having a thermal expansion coefficient similar to that of the epitaxial materials of the solar cell unit 2.

Furthermore, the curing the binder by baking specifically includes: baking the second rigid substrate 5 by placing it on a hot plate furnace to cure the binder 6. The binder 6 is cured by a low temperature baking in the above step without using the bonding scheme in the prior art, to avoid damaging the cell in a high-temperature environment.

As an example, in the present embodiment, the binder 6 is a peelable silica gel of which an adhesion strength to the second rigid substrate 5 is greater than that to the flexible substrate 4. Thus, the binder 6 may be prone to sticking to the second rigid substrate 5 when the second rigid substrate 5 is directly peeled off from the flexible substrate 4 in following steps, it is possible to peel off the second rigid substrate 5 with the binder 6 together from the flexible substrate. As an example, the baking time is preferably 20 minutes, and the baking temperature is less than 90°C.

As an example, in the present embodiment, when the binder 6 coated on the second rigid substrate 5 is in a semi-cured state, the flexible substrate 4 is then attached to the binder 6 on the second rigid substrate 5 for baking and curing, so that it not only ensures that the adhesive between the flexible substrate 4 and the second rigid substrate 5 is stable enough after the binder 6 is cured, but also enables the flexible substrate 4 to be automatically adsorbed by the binder 6 on the second rigid substrate 5 to exhaust air in a contact interface during this process, and thus transfer efficiency and manufacturing quality can be improved. The semi-cured state refers to a state between an uncured state and a fully cured state. Moreover, in the present embodiment, the thermal expansion coefficients of the flexible substrate 4 and the second rigid substrate 5 are similar to that of a cell material, and thus an effect on cell performance by the stress can be greatly reduced during the manufacturing process, so as to improve the quality of flexible solar cells.

Compared with the secondary temporary bonding method in the prior art, in the present embodiment, the flexible substrate 4 is formed by plating the metal thin film prior to manufacturing a front electrode 7 of the flexible solar cell, and the flexible substrate 4 is attached to the second rigid substrate 5 to complete the transfer of the epitaxial layer. The flexible substrate 4 contacts the second rigid substrate 5 to avoid a problem of surface unevenness of a front contact layer 21 after the transfer of the epitaxial layer due to a too large surface roughness of a back contact layer 25 and a problem of high requirements on equipment and high difficulty in bonding the temporary substrate on the back contact layer 25 or the back electrode 3. Moreover, likewise, after the flexible substrate 4 is formed by plating the metal thin film, the surface roughness of the flexible substrate 4 can be further reduced by grinding and polishing so that the surface is smoother and flatter to meet the manufacturing requirements.

S4, separating the first rigid substrate 1 from the solar cell unit 2.

Specifically, the separating the first rigid substrate 1 from the solar cell unit 2 includes: corroding and removing the first rigid substrate 1 on the corrosion barrier layer 11 by a wet peeling process; and
after corroding and removing the first rigid substrate 1 on the corrosion barrier layer 11 by a wet peeling process, the manufacturing method of the flexible solar cell further includes: corroding and removing the corrosion barrier layer 11 on the solar cell unit 2 by the wet peeling process.

In Step S4, according to the wet peeling process, a corrosive solution is used to selectively corrode the first rigid substrate 1 and the corrosion barrier layer 11, and the first rigid substrate (about four inches) and the corrosion barrier layer 11 (about 160 nm in thickness) can be completely removed, which does not damage the cells.

S5, disposing the front electrode 7 on the front surface of the solar cell unit 2.

Specifically, the disposing the front electrode 7 on the front surface of the solar cell unit 2 includes:
plating a front seed layer 71 on the front surface of the solar cell unit 2; and
plating the front electrode 7 on the front seed layer 71.

The front electrodes 7 are arranged on the front surface of the solar cell unit 2 in a comb shape, in an area on the front surface of the solar cell unit 2 that is not covered by the front electrode 7 and the front seed layer 71, the front contact layer 21 needs to be removed to expose the window layer 22, so as to avoid blocking the light. In the present embodiment, the front electrode 7, the back electrode 3 and the flexible substrate 4 is formed by plating, so as to realize disposing the metal thin film layer in a full plating manner. Compared with the prior art inwhich the ohmic contact electrode is formed by electron beam evaporation or megnetron sputtering, the plating in the present disclosure has low requirements for equipment and is low-cost.

As an example, the front electrode 7 is any alloy or metal of AuGe, Ni, Au and Cu, and it has a thickness of less than 500 nm.

S6, peeling off the second rigid substrate 5. As mentioned above, the plated metal thin film is used as the flexible substrate 4 to be attached to the second rigid substrate 5. Since the flexible substrate 4 made of the metal thin film has good flexibility, the second rigid substrate 5 can be directly peeled off from the flexible substrate 4 without damaging the solar cell unit. Meanwhile, the above metal thin film prepared by plating effectively supports the epitaxial layer of the solar cell, and thus avoids fracture of the epitaxial layer caused by adopting the de-bonding operation.

Further, after disposing the front electrode 7 on the front surface of the solar cell unit, the manufacturing method of the flexible solar cell further includes: disposing a passivation layer covering a side wall on the side wall of the solar cell unit 2. The passivation layer is made of an insulating material and is used for protecting the side wall of the solar cell unit to prevent power leakage. As an example, in the present embodiment, the passivation layer is made of a silicon nitride material and has a thickness of 290 to 310 nm, preferably, 300 nm.

Further, after disposing the front electrode 7 on the front surface of the solar cell unit 2, the manufacturing method of the flexible solar cell further includes: disposing an anti-reflectance layer 8 on the front electrode 7 of the solar cell unit and an area on the front surface of the solar cell unit 2 that is not covered by the front electrode.

The anti-reflectance layer 8 can greatly reduce light reflection on the surface of the solar cell such that more photons are absorbed by the solar cell, to improve photoelectric conversion efficiency. The anti-reflectance layer 8 corresponds to an anti-reflective film 90 in embodiment 1. In the present embodiment, the anti-reflective layer 8 is made of four layers of optical films such as TiO₂/SiO₂/TiO₂/SiO₂.

The present disclosure also provides a flexible solar cell made by the above manufacturing method of the flexible solar cell.

Referring to Fig. 8, the present disclosure illustratively prepares a four-inch flexible solar cell. It can be seen from the relationship flowchart between the current density and the voltage under AM 1.5 spectrum that its photoelectric conversion efficiency (Eff) may reaches 28.8%, an open-circuit voltage (Voc) is about 2.74V, a short-circuit current density (Jsc) is about 13.07 mA.cm², and a filling factor (FF) is about 80.76%.

According to the flexible solar cell and the manufacturing method thereof provided in the embodiments of the present disclosure, the flexible substrate 4 prepared on the back electrode 3 is transferred to the second rigid substrate 5 by a binder 6, the binder 6 is cured through a low temperature backing, which avoids damage of cells by a high-temperature condition required for bonding; when the flexible solar cell has been manufactured, the second rigid substrate 5 can be directly peeled off from the flexible substrate 4. Compared with the prior art that requires repeatedly bonding and repeatedly transferring the epitaxial layer, there is no need in the present disclosure to perform the bonding process through a bonder, and the second rigid substrate 5 can be peeled off directly without de-bonding by an additional auxiliary means, this also improves the production efficiency.

It should be explained that the relationship terms, such as first and second, etc., in the present disclosure are only used for distinguishing one entity or operation from another entity or operation without requiring or implying any actual relation or sequence existing between these entities or operations. Moreover, the term "include", "contain" or any other variant means covering instead of exclusively including, so that the process, method, object or device including a series of factors not only includes those factors but also includes other factors that are not explicitly listed or further includes inherent factors for this process, method, object or device. Where no more limitations are provided, the factors defined by the sentence "include one..." do not exclude additional identical factors existing in the process, method, object or device which includes the factors.

The above statements are only the specific embodiments of the present application, it should be pointed out that, to those ordinary skilled in the art, several improvements and polish can be made without breaking away from the principle of the present application, also those improvements and polish should be considered as the protection scope of the present application.

## Claims

1. A manufacturing method of a flexible solar cell, comprising:
disposing a separation layer on a substrate;
flip-chip fabricating a solar cell on the separation layer;
disposing a back electrode on the bottom surface of the solar cell;
disposing a metal thin film on the back electrode;
bonding the metal thin film to a temporary substrate;
separating the separation layer from the solar cell;
disposing a front electrode on the front surface of the solar cell; and
de-bonding the temporary substrate and the metal thin film.

2. The manufacturing method of the flexible solar cell of claim 1, wherein the separation layer is a corrosion barrier layer, wherein the separating the separation layer from the solar cell comprises:
corroding and removing the substrate by using wet peeling; and
peeling off and removing the corrosion barrier layer by using wet peeling.

3. The manufacturing method of the flexible solar cell of claim 1, wherein the separation layer is a sacrificial layer, wherein the separating the separation layer from the solar cell comprises:
removing the sacrificial layer by using wet peeling.

4. The manufacturing method of the flexible solar cell of claim 1, wherein after disposing the front electrode on the front surface of the solar cell, the manufacturing method further comprises:
depositing an anti-reflection film on the front electrode.

5. The manufacturing method of the flexible solar cell of claim 1, wherein the solar cell is a multi-junction solar cell.

6. The manufacturing method of the flexible solar cell of claim 1, wherein the bonding the metal thin film on the temporary substrate comprises bonding the metal thin film and the temporary substrate by using a low temperature bonding adhesive at a low temperature.

7. The manufacturing method of the flexible solar cell of claim 6, wherein the low temperature bonding adhesive is a low temperature cured silica gel.

8. The manufacturing method of the flexible solar cell of claim 6, wherein the de-bonding the temporary substrate and the metal thin film comprises dissolving and removing the low temperature bonding adhesive by using a low temperature adhesive cleaner.

9. The manufacturing method of the flexible solar cell of claim 1, wherein the disposing the metal thin film on the back electrode comprises:
forming the metal thin film by a plating process on the back electrode by using a plating process; and
performing a mechanical-chemical polishing on a surface of the metal thin film.

10. A flexible solar cell prepared by the manufacturing method of the flexible solar cell of claim 1.

11. A manufacturing method of a flexible solar cell, comprising:
disposing an upside-down solar cell unit on a first rigid substrate;
disposing a back electrode and a flexible substrate disposed to be laminated on the bottom surface of the solar cell unit;
attaching the flexible substrate onto a second rigid substrate coated with a binder and curing the binder by baking, to attach the flexible substrate onto the second rigid substrate;
separating the first rigid substrate from the solar cell unit;
disposing a front electrode on the front surface of the solar cell unit; and
peeling off the second rigid substrate.

12. The manufacturing method of the flexible solar cell of claim 11, wherein the disposing the upside-down solar cell unit on a first rigid substrate comprises:
disposing a corrosion barrier layer on the first rigid substrate; and
disposing the upside-down solar cell unit on the corrosion barrier layer.

13. The manufacturing method of the flexible solar cell of claim 11, wherein the disposing a back electrode and a flexible substrate disposed to be laminated on the bottom surface of the solar cell unit comprises:
plating a back seed layer on the bottom surface of the solar cell unit;
plating the back electrode on the back seed layer; and
plating a metal thin film on the back electrode to form the flexible substrate.

14. The manufacturing method of the flexible solar cell of claim 13, wherein the metal thin film is a cooper thin film, and the second rigid substrate is borosilicate glass.

15. The manufacturing method of the flexible solar cell of claim 11, wherein the binder is a peelable silica gel of which an adhesion strength to the second rigid substrate is greater than that to the flexible substrate.

16. The manufacturing method of the flexible solar cell of claim 12, wherein the separating the first rigid substrate from the solar cell unit comprises: corroding and removing the first rigid substrate on the corrosion barrier layer by using a wet peeling process; and
after corroding and removing the first rigid substrate on the corrosion barrier layer by using a wet peeling process, the manufacturing method of the flexible solar cell further comprises corroding and removing the corrosion barrier layer on the solar cell unit by using the wet peeling process.

17. The manufacturing method of the flexible solar cell of claim 11, wherein the disposing the front electrode on the front surface of the solar cell unit comprises:
plating a front seed layer on the front surface of the solar cell unit; and
plating a front electrode on the front seed layer.

18. The manufacturing method of the flexible solar cell of claim 11, wherein after disposing the front electrode on the front surface of the solar cell unit, the manufacturing method of the flexible solar cell further comprises: disposing an anti-reflectance layer on the front electrode of the solar cell unit and an area on the front surface of the solar cell unit that is not covered by the front electrode.

19. The manufacturing method of the flexible solar cell of claim 11, wherein the solar cell unit is a multi-junction solar cell.
